# EUROPEAN PATENT APPLICATION

(11) **EP 4 730 034 A1**
(43) Date of publication of application: **22.04.2026**
(21) Application number: 24207723.8
(22) Date of filing: 21.10.2024
(51) Int. Cl.: G03F 7/00

(54) **SHUTTER ASSEMBLY FOR A LITHOGRAPHIC APPARATUS**

(71) Applicant: ASML Netherlands B.V., 5500 AH Veldhoven (NL)
(72) Inventor: VAN DE KERKHOF, Marcus, Adrianus, 5500AH Veldhoven (NL)
(74) Representative: ASML Netherlands B.V.

(57) **Abstract**

The invention provides a shutter assembly for use in a lithographic apparatus that comprises a shutter and an actuator device for moving the shutter between a closed position and an opened position, wherein an opening duration during which the shutter is moved from the closed position to the opened position differs from a closing duration during which the shutter is moved from the opened position to the closed position.

## Description

### FIELD

The present invention relates to a shutter assembly for use in a lithographic apparatus that comprises a shutter and an actuator device for moving the shutter between a closed position and an opened position. The present invention further relates to a lithographic apparatus comprising such a shutter assembly.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

To this effect, lithographic apparatuses typically comprises a source of radiation, for example for emitting ultraviolet (UV) light pulses, for example EUV light pulses, and a scanner module in between which an aperture is provided to allow passage of the light pulses between the modules. The aperture is typically needed since no windows or the like are available that are transparent to the EUV wavelength of 13.5 nm.

During use, an extended stabilization period of ~20 ms is needed before starting each die exposure. Such stabilization pulses may be absorbed by a reticle mask blade, so as not to obtain undesired illumination of components in the scanner. They will, however, result in heating of the reticle mask blade, thus requiring additional cooling thereof, which would complicate the design thereof.

Furthermore, the stabilization pulses may effect heating and degradation of the mirrors in the scanner module, which may result in increased thermal drift, extra cooling requirements, accelerated deposition of contaminants on the mirrors and accelerated degradation rate.

Finally, tin particles from the source can enter the scanner through the aperture and can deposit on and damage the components of the scanner.

### SUMMARY

It is an object of the present invention to provide a shielding for stabilization pulses to prevent these pulses from reaching components in the scanner module.

According to an aspect of the invention, there is provided a shutter assembly for use in a lithographic apparatus that comprises a shutter and an actuator device for moving the shutter between a closed position and an opened position, wherein an opening duration during which the shutter is moved from the closed position to the opened position differs from a closing duration during which the shutter is moved from the opened position to the closed position.

The shutter assembly is configured to temporarily shield the aperture of the lithographic apparatus when the shutter is arranged in the closed position. In the opened position, the shutter assembly has moved the shutter away from the aperture to allow passage of pulses therethrough. The movement of the shutter between the closed position and the opened position may be a linear movement, to provide for a translation of the shutter, and/or a rotational movement or combinations thereof.

The shutter assembly is able to move the shutter between the opened and closed position in an asymmetric manner. This allows the opening duration to be different from the closing duration. As such, the opening and closing of the shutter can be adjusted to meet specific requirements.

The difference in opening and closing duration may allow the opening duration to be shorter than the closing duration, allowing the shutter to be moved away from the aperture relatively fast. This is advantageous, since it is typically desired to commence the exposure of the mask as a soon as a possible when the source has stabilized. Upon termination of the exposure, on the other hand, the source can be instantaneously deactivated so as to no longer fire pulses, which means that rapid closure of the shutter is of lesser importance.

The asymmetric movements of the shutter may be enabled by applying a pretension force to the shutter with the actuator device, for example by means of an elastic member or a magnetic member, in addition to a controlled actuator. The pretension can be released to work together with the actuator for moving the shutter from the closed position to the opened position. On the other hand, the actuator may be used to pretension the pretension member when moving the shutter from the opened position to the closed position

According to a further aspect of the present invention, there is provided a lithographic apparatus comprising the shutter assembly, in particular as recited in the appended claims. The shutter is positioned in front of the aperture in its closed position, to block the passage of the light pulses and the shutter is moved away from the aperture in its opened position to allow the passage of the light pulses through the aperture.

According to another aspect of the present invention, there is provided a method of operating the lithographic apparatus recited in the appended claims, comprising the steps of moving the shutter to the closed position to block the aperture, emitting, with the source, light pulses towards the shutter with the source until the source has stabilized, and after stabilization of the source, moving shutter to the opened position to allow passage of the UV light pulses through the aperture.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figures 2A and 2B schematically depict a first embodiment of the shutter assembly according to the present invention,
- Figures 3A - 3C schematically depict a second embodiment of the shutter assembly according to the present invention,
- Figures 4A and 4B schematically depict a third embodiment of the shutter assembly according to the present invention, and
- Figure 5 depict a fourth embodiment of the shutter assembly according to the present invention.

### DETAILED DESCRIPTION

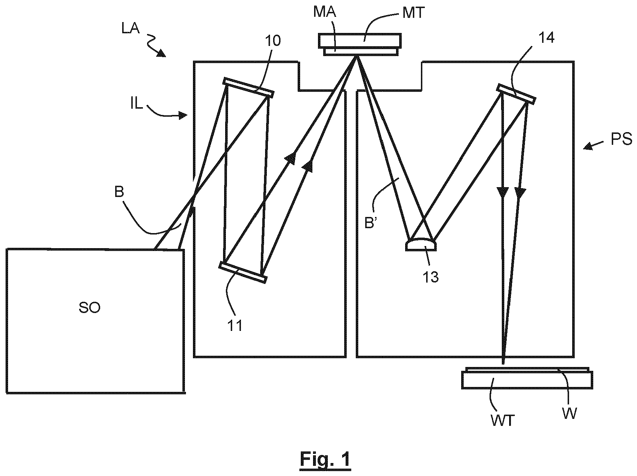

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

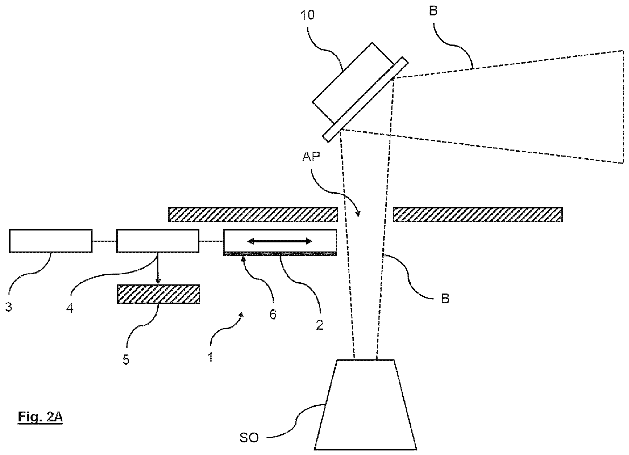

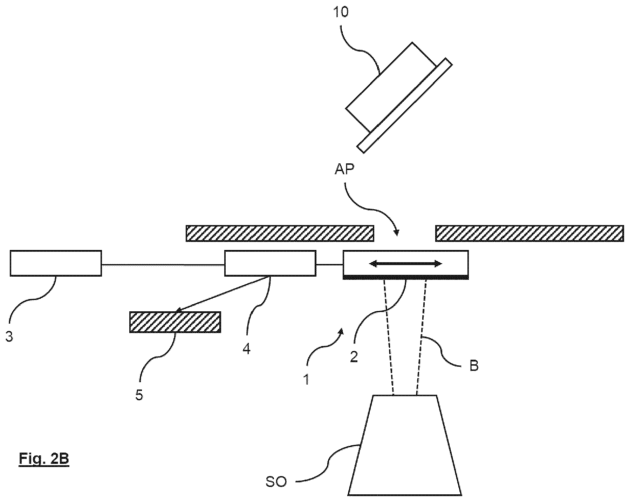

Figures 2A and 2B schematically depict a first embodiment of the shutter assembly according to the present invention, which is disposed at an aperture AP between the radiation source SO and the mirror device 10, and to which is referred with reference numeral 1. The shutter assembly 1 comprises a shutter 2 that is movable between an opened position, shown in figure 2A, in which the EUV radiation beam B of pulses is allowed to pass through the aperture AP, and a closed position, shown in figure 2B, in which the EUV radiation beam B of pulses is blocked to prevent passage through the aperture AP.

The shutter assembly 1 comprises a controllable actuator member, currently embodied as an electromagnetic actuator 3. The actuator 3 is functionally connected to the shutter 2 and is configured to move the shutter 2 between its opened and closed position, in a direction indicated in the figures by a horizontal double arrow.

The shutter assembly 1 further comprises a pretension member for assisting the actuator for moving the shutter 2 from the closed position to the opened position, i.e. to the left in figures 2A and 2B. On the other hand, the pretension member will be pretensioned when the shutter 2 is moved from the opened position to the closed position, i.e. to the right in figures 2A and 2B. This may ensure that the opening duration of the shutter 2 is shorter than the closing duration.

In the embodiment in figures 2A and 2B, the pretension member is an elastic member 4, which is functionally connected to the shutter 2 and to a fixed reference point 5. The elastic member 4 is shown schematically by means of an arrow indicating the direction of the elastic pretension force. It is to be understood that the elastic member 4 can be any suitable type of elastic member, such as a leaf spring or a torsion spring. In the current embodiment, the elastic member 4 applies its pretension force onto the shutter 2 in parallel to the actuator 3.

In figures 2A and 2B, the elastic member 4 exerts a tensional force between the shutter 2 and the reference point 5 to contribute in pulling the shutter 2 from the closed position to the opened position. When returning the shutter 2 from the opened position to the closed position, the actuator 3 will pretension the elastic member, i.e. by elongating it.

The shutter 2 comprises a layer of absorbent material 6 facing the source SO for absorbing light pulses and/or liquid droplets, such as molten tin droplets, when the shutter 2 is in the closed position. This may further contribute in avoiding undesired heating of components and to avoid scattering of UV pulses and/or tin droplets through the lithographic apparatus LA. The shutter 2 also comprises cooling channels (not visible in the figures) for withdrawing heat from the shutter 2.

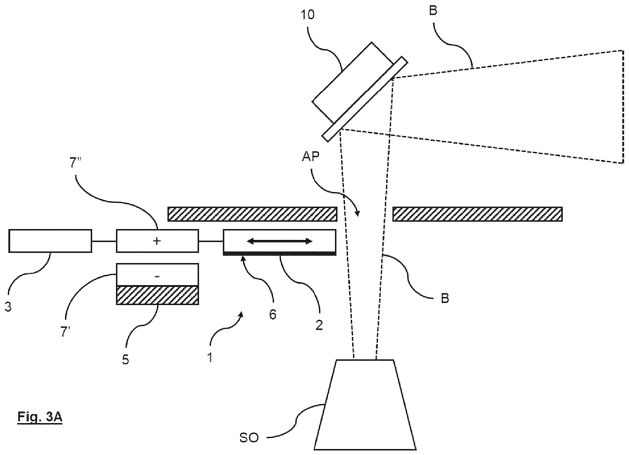

Figures 3A - 3C depict another embodiment of the shutter assembly 1, which comprises magnetic elements 7 instead of elastic elements for pretensioning the shutter 2. The shutter assembly 1 comprises a first magnetic element 7' that is associated with the reference point 5 and a second magnetic element 7" associated with the shutter 2.

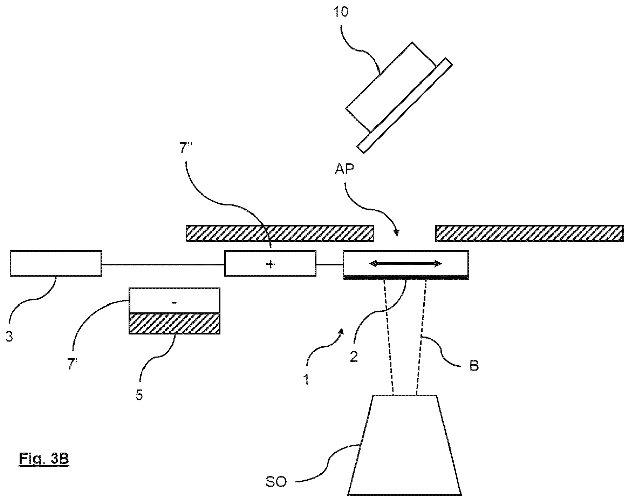

The first magnetic element 7' is an electromagnet of which a magnetic polarity can be adjusted. The second magnetic element 7" is a permanent magnet in the present embodiment. Figures 3A and 3B show that the magnetic elements 7', 7" can be of opposed polarity to attract each other, as is indicated by the "+" and "-" symbols. In the opened position of the shutter 2, as shown in figure 3A, the magnetic elements 7', 7" can be located close to each other. The magnetic elements 7', 7" can be moved away from each other in the closed position of the shutter 2, as in figure 3B, by which a magnetic attractive pretension force is generated for assisting movement of the shutter 2 towards the opened position.

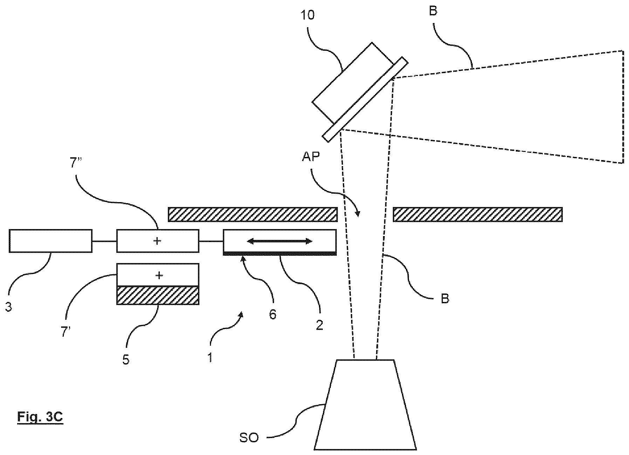

Figure 3C shows that the polarity of the electromagnetic first magnetic element 7' can be reversed, so that the magnetic elements 7', 7" come to repel each other. The repelling magnetic elements 7', 7" assist the actuator 3 for moving the shutter 2 to the closed position. Once the shutter 2 has reached the closed position, the polarity of the electromagnetic first magnetic element 7' can be reversed again, so that the attractive magnetic pretension force is again exerted on the shutter 2.

In alternative embodiments, the pretensioning may be carried out by means of an electrostatic actuator, capable of exerting electrostatic forces between the reference point 5 and the shutter 2, in a manner similar as shown in figures 3A - 3C for the electromagnetic actuator.

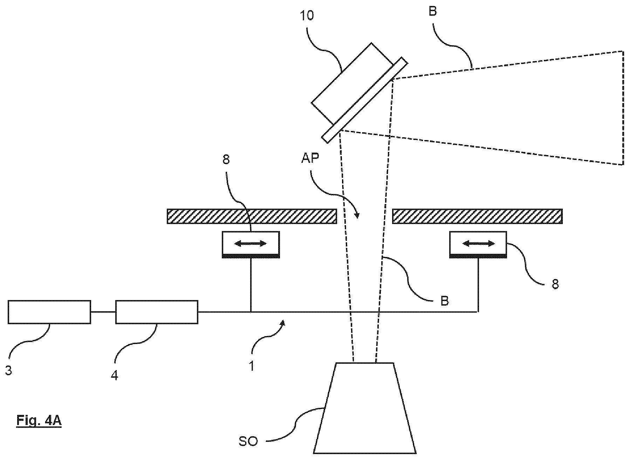

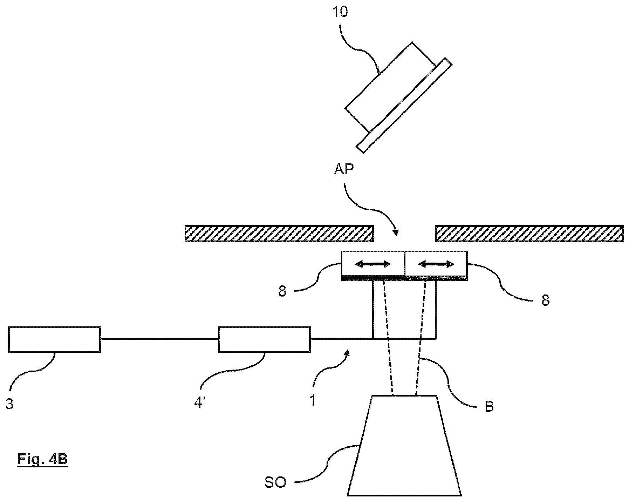

Figures 4A and 4B show a further alternative embodiment of the shutter assembly 1, in which the shutter comprises two complementary shutter blades 8. The shutter blades 8 are jointly associated with the actuator 3 and the pretension member 4', so that the shutter blades 8 can be moved jointly.

In figure 4A, the shutter blades 8 are shown in the opened position, in which they are moved away from each other and spaced away from the aperture AP. In figure 4B, the shutter is moved back into the closed position with the shutter blades 8 moved towards each other to block the radiation beam B from passing the aperture AP.

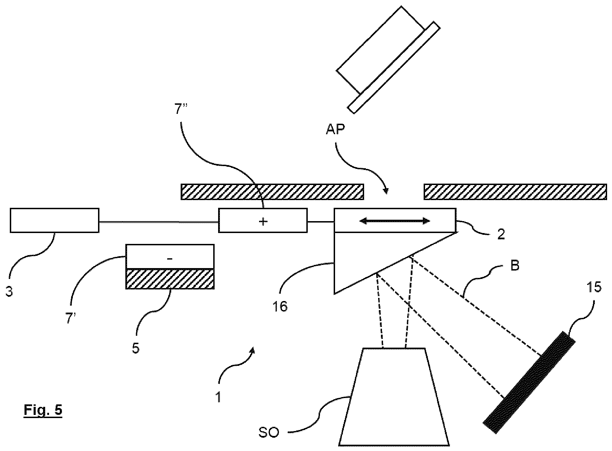

Figure 5 shows another embodiment of the apparatus 1, in which a beam dump 15 is provided to absorb light pulses in the beam B. The shutter 2 comprises a deflector 16 at a bottom surface that faces the source SO. In closed position of the shutter 2, the beam B is deflected by the deflector 16 towards the beam dump 15. In this way, the shutter 2 will not be heated significantly by the beam B and any absorbent layer may be omitted.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A shutter assembly for use in a lithographic apparatus that comprises a shutter and an actuator device for moving the shutter between a closed position and an opened position, wherein an opening duration during which the shutter is moved from the closed position to the opened position differs from a closing duration during which the shutter is moved from the opened position to the closed position.

2. The shutter assembly according to claim 1, wherein the opening duration is shorter than the closing duration.

3. The shutter assembly according to claim 1, wherein the closing duration is shorter than the opening duration.

4. The shutter assembly according to any of the preceding claims, wherein the actuator device comprises a controllable actuator member, for example an electromagnetic actuator.

5. The shutter assembly according to any of the preceding claims, wherein the actuator device comprises a pretension member, which is configured to apply a pretension force on the shutter in the opened position.

6. The shutter assembly according to claim 4 and claim 5, wherein the actuator device is configured to move the shutter from the closed position to the opened position jointly with the actuator member and the pretension member.

7. The shutter assembly according to claim 6, wherein the actuator member is configured to build up the pretension force in the pretension device whilst moving the shutter from the opened position to the closed position, in order to pretension the pretension device.

8. The shutter assembly according to any of the claims 5 - 7, wherein the pretension member comprises an elastic member, for example a leaf spring or a torsion spring, for exerting an elastic pretension force.

9. The shutter assembly according to any of the claims 5 - 8, wherein the pretension member comprises a magnetic member, for example a pair of attracting or repelling magnetic elements, for exerting a magnetic pretension force.

10. The shutter assembly according to any of the claims 5 - 9, wherein the pretension member comprises an electrostatic actuator member, for exerting an electrostatic pretension force.

11. The shutter assembly according to claim 4 and any of the claims 5 - 10, wherein the actuator member and the pretension member are functionally associated with the shutter in parallel.

12. The shutter assembly according to any of the preceding claims, wherein the shutter is formed of multiple complementary shutter blades, each moved away from each other in the opened position and moved towards each other in the closed position to jointly form the shutter.

13. The shutter assembly according to claim 12, wherein the actuator device is functionally arranged between the shutter blades.

14. A lithographic apparatus, such as an Extreme Ultraviolet (EUV) lithographic apparatus, comprising a source of ultraviolet (UV) light pulses, for example EUV light pulses, a scanner module and an aperture in between the source and the scanner module allowing passage of the light pulses from the source to the scanner,
wherein the apparatus further comprising the shutter assembly according to any of the preceding claims, wherein the shutter is positioned in front of the aperture in its closed position to block the passage of the light pulses and wherein the shutter is positioned away from the aperture in its opened position to allow the passage of the light pulses through the aperture.

15. The lithographic apparatus according to claim 14, wherein the shutter comprises absorbent material for absorbing light pulses and/or liquid droplets, such as molted tin droplets, when the shutter is in the closed position.

16. The lithographic apparatus according to claim 14 or 15, wherein the shutter comprises one or more cooling channels for guiding a flow of a cooling medium in order to withdraw heat from the shutter resulting from incident light pulses.

17. The lithographic apparatus according to any of the claims 14 - 16, further comprising a beam dump, configured to absorb UV light pulses, wherein the shutter is configured to deflect the UV light pulses to the beam dump when it is positioned in the closed position.

18. Method of operating the lithographic apparatus according to any of the claims 14 - 17, comprising the steps of:
- moving the shutter to the closed position to block the aperture,
- emitting, with the source, light pulses towards the shutter with the source until the source has stabilized, and
- after stabilization of the source, moving shutter to the opened position to allow passage of the UV light pulses through the aperture.

19. Method according to claim 18, wherein an opening duration during which the shutter is moved to the opened position differs from a closing duration during which the shutter is moved to the closed position.

20. Method according to claim 19, whereon the opening duration is shorter than the closing duration, wherein for example the opening duration is 2 ms.
